# EUROPÄISCHE PATENTSCHRIFT

(11) **EP 2 301 092 B1**
(45) Veröffentlichungstag und Bekanntmachung des Hinweises auf die Patenterteilung: **22.05.2019**
(21) Anmeldenummer: 09775897.3
(22) Anmeldetag: 19.06.2009
(51) Int. Cl.: H01L 51/52

(54) **VERKAPSELTES OPTOELEKTRONISCHES BAUELEMENT UND VERFAHREN ZU DESSEN HERSTELLUNG**
ENCAPSULATED OPTOELECTRONIC COMPONENT AND METHOD FOR THE PRODUCTION THEREOF
COMPOSANT OPTOELECTRONIQUE ENCAPSULE ET SON PROCEDE DE FABRICATION

(30) Priorität: 14.07.2008 DE 102008033017
(43) Veröffentlichungstag der Anmeldung: 30.03.2011
(73) Patentinhaber: OSRAM OLED GmbH, 93049 Regensburg (DE)
(72) Erfinder: HEUSER, Karsten, 91056 Erlangen (DE); SCHMID, Christian, 93049 Regensburg (DE); SCHLENKER, Tilman, 93152 Nittendorf (DE); GRÖPPEL, Peter, 91052 Erlangen (DE)
(74) Vertreter: Epping - Hermann - Fischer
(86) Internationale Anmeldenummer: PCT/DE2009/000858
(87) Internationale Veröffentlichungsnummer: WO 2010/006571

(56) Entgegenhaltungen:
- EP-A- 1 849 593
- JP-A- 2004 152 590
- JP-A- 2004 152 664
- JP-A- 2004 192 822

## Beschreibung

Es wird ein Verfahren zur Verkapselung eines optoelektronischen Bauelements nach dem Anspruch 1 angegeben.

Ein weit verbreitetes Problem bei der Herstellung von optoelektronischen Bauelementen ist deren Verkapselung zum Schutz gegenüber Umwelteinflüssen. Bei gängigen Verkapselungstechniken treten immer noch Pinholes oder Defekte in der Verkapselungsschicht auf, welche zu Undichtigkeiten führen. Durch diese Undichtigkeiten können beispielsweise Luftfeuchtigkeit aus der Umgebung zu dem optoelektronischen Bauelement vordringen und dieses mit der Zeit zerstören.

Bei dem optoelektronischen Bauelement kann es sich beispielsweise um eine organische lichtemittierende Diode (OLED) handeln. Eine OLED kann beispielsweise folgende Schichtenfolge umfassen: eine Anode, eine Kathode und zwischen den beiden angeordnet eine strahlungsemittierende Schicht. Die strahlungsemittierende Schicht kann hierbei ein organisches Material umfassen. Die Löcher, welche im Betrieb von der Anode abgegeben werden, rekombinieren mit den Elektroden, welche von der Kathode abgegeben werden, in der strahlungsemittierende Schicht. Die durch die Rekombination freigesetzte Energie kann in der strahlungsemittierenden Schicht Moleküle zur Emission von Strahlung anregen. Bei der OLED handelt es sich um ein optoelektronisches elektrolumineszierendes Bauelement. Eine OLED kann beispielsweise als weitere Schichten umfassen: eine löcherinduzierende Schicht, eine löchertransportierende Schicht, eine elektronentransporiterende Schicht und / oder eine elektroneninduzierende Schicht. Bei dem optoelektronischen Bauelement kann es sich auch um andere Formen von elektrolumineszierenden Bauelementen, sowie um nicht elektrolumineszierende Bauelemente handeln.

Das Problem wird derzeit dadurch gelöst, dass das optoelektronische Bauelement durch ein Gehäuse überdeckt wird und der Zwischenraum zwischen dem Bauelement und dem Gehäuse noch zusätzlich einen Getter enthält. Ein Getter ist ein Material, welches von außen eindringende störende Substanzen wie beispielsweise das Wasser der Luftfeuchtigkeit absorbiert oder adsorbiert. Probleme dieser Gehäusetechnik sind, dass die Stellen an denen das Gehäuse mit dem Trägersubstrat verbunden wird, bisher noch nicht ausreichend abgedichtet werden können, was somit beispielsweise zum Eindringen von Luftfeuchtigkeit führt. Des Weiteren ist diese Technik sehr aufwendig und kostspielig. Der Getter hat auch nur eine begrenzte Kapazität nach der er gesättigt ist und keine weiteren Stoffe mehr aufnehmen kann. Gerade für großflächige optoelektronische Bauelemente lässt sich diese Methode aus Kostengründen nicht umsetzen. Unter einem "großflächigen" optoelektronischen Bauelement wird gemäß einer Ausführungsform der Erfindung ein optoelektronisches Bauelement verstanden, dessen Fläche größer oder gleich als 3 mm² ist. Auch ist es schwierig, mit dieser Methode sehr dünne optoelektronische Bauelemente herzustellen.

Die Druckschrift EP 1 849 593 A1 betrifft eine Gasbarrierenschicht für eine organische Leuchtdiode.

Aus der Druckschrift JP 2004-152590 A ist eine organische Leuchtdiode bekannt, die eine Metalloxid-Schutzschicht, abgeschieden mittels eines Atmosphärendruckplasmas, aufweist.

Ein Display mit einer organischen Licht emittierenden Schicht ist aus der Druckschrift JP 2004-152664 A bekannt.

In der Druckschrift JP 2004-192822 A sind eine organische Leuchtdiode und ein Herstellungsverfahren hierfür offenbart.

Eine Aufgabe dieser Erfindung besteht darin, ein Verfahren bereitzustellen, mit dem ein optoelektronisches Bauelement zum Schutz gegen Umwelteinflüsse dicht verkapselt werden kann.

Die Aufgabe wird durch ein Verfahren zur Verkapselung eines optoelektronischen Bauelements nach dem Anspruch 1 gelöst. Weitere Verfahrensvarianten sowie das optoelektronische Bauelement selbst sind Gegenstand weiterer Patentansprüche.

Das Verfahren zur Verkapselung eines optoelektronischen Bauelements umfasst die Verfahrensschritte A) das Bereitstellen des optoelektronischen Bauelements, sowie B) das Abscheiden einer Diffusionsbarriere zum Schutz gegen Umwelteinflüsse mittels eines Atmosphärendruckplasmas auf zumindest einem Teilbereich der Oberfläche des optoelektronischen Bauelements.

Durch das Abscheiden der Diffusionsbarriere mittels Atmosphärendruckplasmas kann sichergestellt werden, dass die abgeschiedene Schicht eine sehr hohe Dichtigkeit aufweist. Die Diffusionsbarriere weist keine oder so gut wie keine Pinholes oder Defekte auf. Es wird eine deutlich höhere Dichtigkeit erreicht als bei den gängigen Dünnfilmverkapselungsvarianten. Somit kann das optoelektronische Bauelement durch die Atmosphärendruckplasmaverkapselung effektiv vor Umwelteinflüssen geschützt werden. Diese Methode eignet sich auch für sehr großflächige Anwendungen.

Die Verwendung eines Atmosphärendruckplasmas weist gegenüber der Nutzung einer Niederdruckplasmatechnik einige Vorteile auf. Der apparative Aufwand des Atmosphärendruckplasmas ist deutlich geringer als beim Niederdruckplasma. Beim Niederdruckplasma ist es notwendig, dass das zu beschichtende Bauelement in eine Kammer eingebracht wird, in dieser dann der Druck vermindert wird, nach dem Abscheideprozess der Druck wieder auf Normaldruck angepasst wird und das Bauelement wieder aus der Kammer herausgeholt wird. Bei der Verwendung des Atmosphärendruckplasmas ist es hingegen nicht notwendig, das Bauelement in eine geschlossene Kammer einzubringen. Hier ist es möglich, dass das Bauelement unter Normalbedingungen, das heißt in Luftatmosphäre unter Normaldruck beschichtet werden kann. Dies ist somit beispielsweise auch direkt auf einem Fließband möglich. Aufgrund dessen, dass hier keine räumliche Einschränkung vorliegt, ist es deutlich einfacher, mit beispielsweise Maschinen die zur Abscheidung eingesetzt werden gezielt nur Einzelpunkte auf dem Bauelement anzusteuern und nicht wie in der Niederdruckkammer die gesamte Oberfläche zu beschichten. Der Einsatz des Atmosphärendruckplasmas kann auch unter Schutzgasatmosphäre erfolgen.

Die Diffusionsbarriere kann hierbei in einer Dicke von 50 nm bis 1000 nm abgeschieden werden. Vorzugsweise wird sie in einer Dicke von 100 nm bis 250 nm abgeschieden. Diese Verkapselungstechnik ermöglicht somit die Herstellung von sehr dünnen optoelektronischen Bauelementen, welche trotzdem eine sehr hohe Dichtigkeit gegenüber Umwelteinflüssen aufweisen. Dieses Verfahren lässt sich auch sehr gut für großflächige Bauelemente anwenden, da hier im Gegensatz zur Gehäusetechnik bei der die Fertigung von sehr großen Gehäusen ein Problem darstellt, hier die Größe des optoelektronischen Bauelements aus technischer Sicht keine Rolle spielt.

Die Diffusionsbarriere kann in dem Verfahren mittels Abscheidens von Einzelschichten erzeugt werden. Hierbei können zwei oder mehrere Einzelschichten übereinander abgeschieden werden. Jede der Einzelschichten kann eine Dicke von beispielsweise 50 bis 100 nm aufweisen. Durch das Aufbringen von Einzelschichten kann die Dichtigkeit der Gesamtschicht nochmals erhöht werden. Des Weiteren können somit auf dem Bauelement an verschiedenen Stellen Schichten mit unterschiedlichen Dicken erzeugt werden.

Die Diffusionsbarriere kann SiO₂ umfassen. Vorzugsweise besteht die Gesamtdiffusionsbarriere aus amorphen SiO₂. Das SiO₂ kann hierbei erst in der Gasphase gebildet werden. Zur Bildung des SiO₂ kann ein Silan und eine weitere Verbindung, welche als Sauerstoffquelle dient, verwendet werden. Als Silan kann beispielsweise SiH₄ verwendet werden und als Sauerstoffquelle beispielsweise N₂O.

Es wird für das Abscheiden im Verfahrensschritt B) auf Teilbereichen des optoelektronischen Bauelements ein Plasmastrahl verwendet. Dies ermöglicht es, dass die Diffusionsbarriere gezielt auf Teilbereiche abgeschieden werden kann. Der Plasmastrahl kann hierbei mit einer Geschwindigkeit von 5 bis 1000 m pro Minute über die zu beschichtende Oberfläche des Bauelements geführt werden. Die Diffusionsbarriere kann somit je nach Bedarf auf sehr kleinen beispielsweise punktuellen Teilbereichen, wie aber auch auf sehr großflächigen Bereichen des Bauelements abgeschieden werden.

Das Plasma kann in einer Verfahrensvariante in einer Plasmadüse erzeugt werden. In der Plasmadüse kann es zu einem Plasmastrahl geformt werden. Dem Plasmastrahl kann in der Plasmadüse eine Vorstufe zugeführt werden aus der dann das Material entsteht, welches die Diffusionsbarriereschicht ausbildet. Hierbei kann es sich auch um mehrere Vorstufen handeln. Es können beispielsweise somit zwei Vorstufen im Plasmastrahl reagieren und das Reaktionsprodukt dieser Reaktion dann auf der Oberfläche des optoelektronischen Bauelements abgeschieden werden.

Bei den Vorstufen kann es sich beispielsweise um ein Silan und eine Verbindung handeln, welche als Sauerstoffquelle dient.

In einer Verfahrensvariante wird in der Plasmadüse mittels Hochspannungsentladung ein gepulster Lichtbogen erzeugt. Für die Hochspannungsentladung kann eine Spannung verwendet werden, welche im Bereich von 5 bis 30 kV liegt. Für die Hochspannungsentladung kann eine Frequenz verwendet werden, welche im Bereich von 10 bis 100 kHz liegt. In einer anderen Verfahrensvariante wird eine Gleichstromentladung verwendet.

Es umfasst der Verfahrensschritt A) die folgenden Teilverfahrensschritte:
A1) das Bereitstellen eines Substrates,
A2) das Aufbringen einer ersten Elektrodenschicht auf das Substrat,
A3) das Aufbringen einer organischen Funktionsschicht auf die erste Elektrodenschicht, sowie
A4) das Aufbringen einer zweiten Elektrodenschicht auf die organische Funktionsschicht, wobei ein die erste Elektrodenschicht, die zweite Elektrodenschicht sowie die organische Funktionsschicht umfassender Schichtstapel gebildet wird.

Über die Teilverfahrensschritte A1) bis A4) wird somit ein Schichtstapel des optoelektronischen Bauelements erzeugt. Bei der organischen Funktionsschicht kann es sich beispielsweise um eine lichtemittierende Schicht handeln. Die beiden Elektrodenschichten dienen zur elektrischen Kontaktierung des Bauelements.

Es umfasst der Verfahrensschritt A) als weiteren Teilverfahrensschritt A5) das Aufbringen einer ersten Verkapselungsschicht auf die zweite Elektrodenschicht. Die Verkapselungsschicht dient zur Verkapselung des optoelektronischen Bauelements und somit zum Schutz gegen Umwelteinflüsse.

Der in den Teilverfahrensschritten A1) bis A4) generierte Schichtstapel weist Hauptoberflächen auf, welches die Außenflächen sind, die parallel zur Schichtenfolge verlaufen. Des Weiteren weist der Schichtstapel Seitenoberflächen auf, welche die Außenflächen sind, die senkrecht zur Schichtenfolge verlaufen. Ein optoelektronisches Bauelement wird dadurch verkapselt, dass die Diffusionsbarriere auf den Seitenoberflächen des Schichtstapels abgeschieden wird.

In einer weiteren Verfahrensvariante wird in einem zusätzlichen Verfahrensschritt nach dem Teilverfahrensschritt A4) eine Dünnfilmverkapselungsschicht auf die zweite Elektrodenschicht aufgebracht. Durch die Dünnfilmverkapselungsschicht wird das optoelektronische Bauelement schon vorgekapselt. Das optoelektronische Bauelement besitzt danach schon eine erste Grunddichtigkeit gegenüber Umwelteinflüssen.

In einem zusätzlichen Verfahrensschritt wird zwischen den Teilverfahrensschritten A1) und A2) eine leitfähige transparente Schicht auf das erste Substrat aufgebracht.

In einer weiteren Verfahrensvariante wird in einem zusätzlichen Verfahrensschritt eine zweite Verkapselungsschicht auf die Dünnfilmverkapselungsschicht aufgebracht. Durch die Kombination der beiden unterschiedlichen Verkapselungsschichten wird ein besonders hohes Maß an Dichtigkeit erreicht.

Für die erste Verkapselungsschicht wird eine Deckplatte verwendet. Dies ermöglicht es, beispielsweise bei sehr großflächigen Bauelementen, schnell und effizient eine oder auch beide Hauptoberflächen des Schichtstapels abzudichten. Das optoelektronische Bauelement kann somit ohne große Strahlungsverluste beispielsweise durch die Hauptoberfläche, die beispielsweise mit einer Deckplatte aus Glas verkapselt wurde, abstrahlen. Es müssen dann noch die Seitenoberflächen des Schichtstapels dicht verkapselt werden. Dies erfolgt durch das Abscheiden der Diffusionsbarriere auf den Seitenoberflächen des Schichtstapels.

In einer Abwandlung wird für die erste Verkapselungsschicht ein Lack verwendet. Die Lackschicht kann beispielsweise auf einer zuvor abgeschiedenen Diffusionsbarriere aufgebracht werden. Bei dieser Abwandlung kann die Lackschicht beispielsweise als Kratzschutz dienen. Es ist aber auch eine Abwandlung möglich, in der zuerst die Lackschicht beispielsweise auf die zweite Elektrodenschicht aufgebracht wird, und erst dann in einem folgenden Verfahrensschritt die Diffusionsbarriere auf die Lackschicht aufgebracht wird. Bei dieser Abwandlung kann der Schichtstapel beziehungsweise die zweite Elektrodenschicht durch die Lackschicht vor dem Plasmastrahl geschützt werden, mit welchem die Diffusionsbarriere abgeschieden wird.

Das optoelektronische Bauelement wird so verkapselt, dass zwischen dem Bauelement und der Verkapselung keine Kavität, also keine Hohlräume entstehen.

Neben dem Verfahren zur Verkapselung des optoelektronischen Bauelements wird auch das optoelektronische Bauelement selbst beansprucht.

Es umfasst das optoelektronische Bauelement hierbei ein erstes Substrat, eine erste Elektrodenschicht angeordnet auf dem ersten Substrat, eine organische Funktionsschicht angeordnet auf der ersten Elektrodenschicht, eine zweite Elektrodenschicht angeordnet auf der organischen Funktionsschicht, eine erste Verkapselungsschicht angeordnet auf der zweiten Elektrodenschicht sowie eine Diffusionsbarriere aus SiO₂, welche auf zumindest einem Teilbereich der Oberfläche des Bauelements mittels Atmosphärendruckplasmas abgeschieden wurde.

Das optoelektronische Bauelement umfasst des Weiteren eine leitfähige transparente Schicht, welche auf dem ersten Substrat angeordnet ist.

In einer weiteren Ausführungsform umfasst das optoelektronische Bauelement eine Dünnfilmverkapselungsschicht, welche auf der zweiten Elektrodenschicht angeordnet ist.

In einer weiteren Ausführungsform umfasst das optoelektronische Bauelement eine zweite Verkapselungsschicht, welche auf der Dünnfilmverkapselungsschicht angeordnet ist.

Es umfasst das Bauelement eine Deckplatte als erste Verkapselungsschicht.

In einer Abwandlung umfasst das Bauelement eine Lackschicht als erste Verkapselungsschicht.

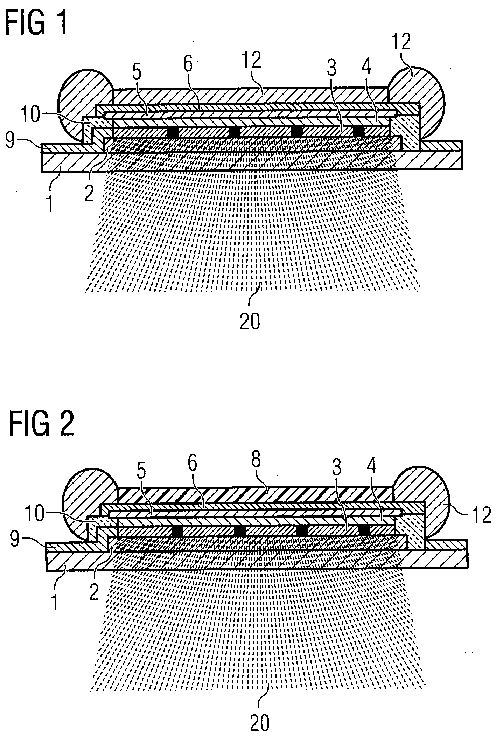

Es umfasst das Bauelement eine erste Verkapselungsschicht, welche mittels Atmosphärendruckplasma abgeschieden wurde. Im Folgenden sollen Abwandlungen und ein Ausführungsbeispiel der Erfindung anhand von Figuren näher erläutert werden. Die Figuren 1 bis 4 zeigen jeweils eine schematische Seitenansicht einer nicht erfindungsgemäßen Abwandlung des optoelektronischen Bauelements.

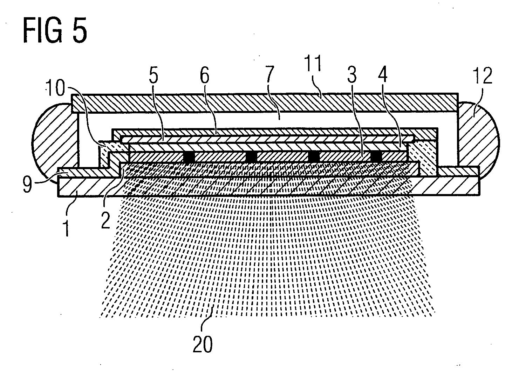

Die Figur 5 zeigt eine schematische Seitenansicht einer Ausführungsform des optoelektronischen Bauelements.

Die Figur 1 zeigt die schematische Seitenansicht einer möglichen Abwandlung des optoelektronischen Bauelements. Die Figur 1 zeigt die Schichtenfolge Substrat 1, darauf angeordnet eine leitfähige transparente Schicht 2, darauf angeordnet eine erste Elektrodenschicht 3, auf dieser ist die organische Funktionsschicht 4 angeordnet. Auf die organische Funktionsschicht 4 folgt die zweite Elektrodenschicht 5. Die erste Elektrodenschicht 3 ist elektrisch leitend über die Kontaktierung 9 verbunden. Durch die Isolationsschicht 10 ist die erste Elektrodenschicht 3 von der zweiten Elektrodenschicht 5 elektrisch isoliert. Durch ein Anlegen einer elektrischen Spannung an die erste Elektrodenschicht 3 und die zweite Elektrodenschicht 5 fließt somit ein Strom durch die organische Funktionsschicht 4. In der organischen Funktionsschicht kann beispielsweise sichtbare Strahlung erzeugt werden, die dann beispielsweise über die Unterseite des Bauelements als sichtbare Strahlung 20 abgegeben werden kann.

Es sind auch Ausführungsbeispiele denkbar, in denen die Strahlung über die Oberseite abgegeben werden kann.

Auf die zweite Elektrodenschicht 5 folgt gemäß Figur 1 eine Dünnfilmverkapselung 6. Die Dünnfilmverkapselung 6 dient zur Vorkapselung des optoelektronischen Bauelements, so dass dieses schon eine erste Grunddichtigkeit gegenüber Umwelteinflüssen aufweist. Die Dünnfilmverkapselung kann beispielsweise mit einem PE-CVD-Verfahren (plasma enhanced chemical vapor deposition) aufgebracht werden. Die Dünnfilmverkapselung 6 kann beispielsweise aus Oxid- oder Nitridschichten wie SiO oder SiN bestehen. Es ist auch eine Mehrschichtkombination aus Nitrid und Oxidschichten denkbar.

Da eine solche Dünnfilmverkapselung 6 jedoch Pinholes oder andere Undichtigkeiten aufweisen kann, sind weitere Verkapselungselemente notwendig.

Das Bauelement in Figur 1 umfasst auf der Dünnfilmverkapselung 6 eine Diffusionsbarriere 12, welche mittels Atmosphärendruckplasma abgeschieden wurde. Die Diffusionsbarriere 12 ist in dieser Abwandlung sowohl auf der oberen Hauptoberfläche wie auch an den Seitenoberflächen des Schichtstapels abgeschieden. Somit ist der Schichtstapel des Bauelements sowohl von der Oberseite wie auch von den Seiten her komplett durch die Diffusionsbarriere 12 verkapselt und somit vor Umwelteinflüssen geschützt. Die Diffusionsbarriere 12 kann mittels Atmosphärendruckplasmas in mehreren Einzelschichten aufgetragen werden, somit können die unterschiedlichen Teilbereiche unterschiedliche Dicken der Diffusionsbarriere 12 aufweisen.

Die Figur 2 zeigt eine weitere Abwandlung des optoelektronischen Bauelements. Diese Abwandlung umfasst wie die in Figur 1 dargestellte Abwandlung ebenfalls die Schichtenfolge Substrat 1, leitfähige transparente Schicht 2, erste Elektrodenschicht 3, darauf angeordnet die organische Funktionsschicht 4, sowie darauf angeordnet die zweite Elektrodenschicht 5. Diese Abwandlung umfasst ebenfalls die Kontaktierung 9, die Isolationsschicht 10, sowie die Dünnfilmverkapselung 6, welche auf der zweiten Elektrodenschicht 5 angeordnet ist. Auf der Dünnfilmverkapselung 6 ist in dieser Ausführungsform eine Lackschicht 8 angeordnet.

In dieser Abwandlung ist somit die Hauptoberfläche durch die Kombination Dünnfilmverkapselung 6 und Lackschicht 8 verkapselt. Die Seitenoberflächen des Schichtstapels sind in dieser Abwandlung ebenso wie in der in Figur 1 dargestellten Abwandlung durch die Diffusionsbarriere 12, welche mit Atmosphärendruckplasma abgeschieden wurde, verkapselt. Die Abscheidung der Diffusionsbarrieren 12 mittels Atmosphärendruckplasma hat somit bei dieser Abwandlung nur an den Seitenoberflächen stattgefunden.

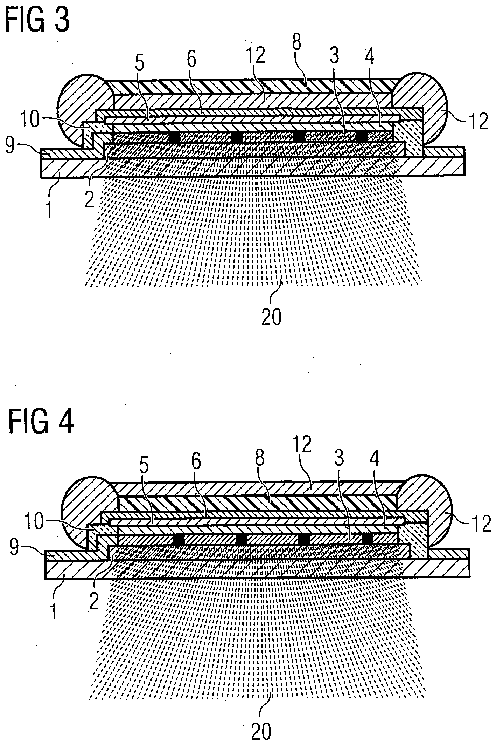

Die Figur 3 zeigt eine schematische Seitenansicht einer weiteren Abwandlung des optoelektronischen Bauelements. Die in Figur 3 dargestellte Abwandlung kann beispielsweise aus der in Figur 1 dargestellten Abwandlung hervorgehen, dadurch, dass auf der Diffusionsbarriere 12, welche mittels Atmosphärendruckplasma abgeschieden wurde, noch eine Lackschicht 8 aufgebracht wurde. Die Lackschicht 8 kann beispielsweise als Kratzschutz für die Diffusionsbarriere 12 dienen.

Die Figur 4 zeigt eine schematische Seitenansicht einer weiteren Abwandlung des optoelektronischen Bauelements. Die in Figur 4 dargestellte Abwandlung kann beispielsweise aus der in Figur 2 dargestellten Abwandlung hervorgehen, dadurch, dass auf der Lackschicht 8 eine Diffusionsbarriere 12 mittels Atmosphärendruckplasma abgeschieden wurde. Die auf der Hauptoberfläche abgeschiedene Diffusionsbarriere 12 geht hierbei in die auf den Seitenoberflächen abgeschiedene Diffusionsbarrieren 12 über. Hierdurch ist das Bauelement an der oberen Hauptoberfläche sowie an den Seitenoberflächen komplett durch die Diffusionsbarriere verkapselt. Die Lackschicht 8 unter der Diffusionsbarriere 12 kann beispielsweise das Bauelement beim Abscheiden der Diffusionsbarriere 12 mittels Atmosphärendruckplasma schützen.

Die Figur 5 zeigt eine schematische Seitenansicht einer Ausführungsform des optoelektronischen Bauelements. Dieses umfasst die Schichtenfolge Substrat 1, leitfähige transparente Schicht 2, erste Elektrodenschicht 3, darauf angeordnet die organische Funktionsschicht 4, sowie darauf folgend die zweite Elektrodenschicht 5. Diese Ausführungsform umfasst des Weiteren die Kontaktierung 9 sowie die Isolationsschicht 10, und die auf der zweiten Elektrodenschicht 5 angeordnete Dünnfilmverkapselung 6.

Auf der Dünnfilmverkapselung 6 sowie um die Seitenoberflächen des Schichtstapels ist eine zweite Verkapselungsschicht 7 aufgebracht. Diese zweite Verkapselungsschicht 7 kann zur Vorkapselung des Bauelements dienen wie auch zur Planarisierung der Dünnfilmverkapselung 6. Die zweite Verkapselungsschicht 7 kann beispielsweise ein transparentes Epoxid umfassen. Auf die zweite Verkapselungsschicht 7 folgt in dieser Ausführungsform eine Deckplatte 11. Bei der Deckplatte handelt es sich um ein Glassubstrat.

Bei Ausführungsformen, bei denen die Strahlung 20 nach unten emittiert wird, ist es auch möglich, Deckplatten 11 zu verwenden, welche nicht transparent sind. Die Verwendung einer Deckplatte 11 ermöglicht es, auch große beziehungsweise großflächige Bauelemente schnell und effizient an eine oder auch beiden Hauptoberflächen zu verkapseln. Die Seitenoberflächen des Schichtstapels bzw. sowie die Seitenoberflächen der zweiten Verkapselungsschicht 7 werden durch die Diffusionsbarriere 12, welches mittels Atmosphärendruckplasma abgeschieden wurde, verkapselt. Somit ist das Bauelement zur Unterseite über das Substrat zur Oberseite über die Deckplatte und an den Seitenoberflächen über die Diffusionsbarriere 12 vollständig abgekapselt.

Die Erfindung ist nicht durch die Beschreibung anhand der Ausführungsbeispiele beschränkt.

## Patentansprüche

1. Verfahren zur Verkapselung eines optoelektronischen Bauelements umfassend die Verfahrensschritte:
A) Bereitstellen des optoelektronischen Bauelements umfassend die folgenden Teilverfahrensschritte:
A1) Bereitstellen eines Substrates (1),
A1') Aufbringen einer leitfähigen transparenten Schicht (2) auf das Substrat (1),
A2) Aufbringen einer ersten Elektrodenschicht (3) auf die leitfähige transparente Schicht (2),
A3) Aufbringen einer organischen Funktionsschicht (4) auf die erste Elektrodenschicht (3),
A4) Aufbringen einer zweiten Elektrodenschicht (5) auf die organische Funktionsschicht (4),
wobei ein die erste Elektrodenschicht (3), die zweite Elektrodenschicht (5) sowie die organische Funktionsschicht (4) umfassender Schichtstapel gebildet wird, der Hauptoberflächen und Seitenoberflächen aufweist,
A5) Aufbringen einer ersten Verkapselungsschicht auf die zweite Elektrodenschicht (5), wobei eine Deckplatte aus Glas (11) mit einer vom Schichtstapel abgewandten Hauptoberfläche und Seitenoberflächen für die erste Verkapselungsschicht verwendet wird,
B) Gezieltes Abscheiden einer Diffusionsbarriere (12) zum Schutz gegen Umwelteinflüsse mittels eines Atmosphärendruckplasmas auf den Seitenoberflächen des Schichtstapels und auf Teilen der Seitenoberflächen der Deckplatte,
wobei
- für das gezielte Abscheiden auf die Seitenoberflächen des Schichtstapels und auf Teile der Seitenoberflächen der Deckplatte ein Plasmastrahl verwendet wird,
- die vom Schichtstapel abgewandte Hauptoberfläche der Deckplatte frei von der Diffusionsbarriere bleibt, und
- das optoelektronische Bauelement so verkapselt wird, dass keine Kavität zwischen der Diffusionsbarriere (12) und dem Bauelement entsteht.

2. Verfahren nach dem vorhergehenden Anspruch,
wobei die Diffusionsbarriere (12) in einer Dicke von 50 nm bis 1000 nm abgeschieden wird.

3. Verfahren nach einem der vorhergehenden Ansprüche,
wobei die Diffusionsbarriere (12) in zumindest zwei Einzelschichten von einer Dicke von jeweils 50 bis 100 nm abgeschieden wird.

4. Verfahren nach einem der vorhergehenden Ansprüche,
wobei in einem zusätzlichen Verfahrensschritt nach A4) eine Dünnfilmverkapselungsschicht (6) auf die zweite Elektrodenschicht (5) aufgebracht wird.

5. Verfahren nach dem vorhergehenden Anspruch,
wobei in einem zusätzlichen Verfahrensschritt eine zweite Verkapselungsschicht (7) auf die Dünnfilmverkapselungsschicht (6) aufgebracht wird.

6. Optoelektronisches Bauelement umfassend
- einen Schichtstapel mit Hauptoberflächen und Seitenoberflächen, umfassend
- ein erstes Substrat (1),
- eine leitfähige transparente Schicht (2) angeordnet auf dem ersten Substrat (1),
- eine erste Elektrodenschicht (3) angeordnet auf der leitfähigen transparenten Schicht (2),
- eine organische Funktionsschicht (4) angeordnet auf der ersten Elektrodenschicht (3),
- eine zweite Elektrodenschicht (5) angeordnet auf der organischen Funktionsschicht (4),
- eine erste Verkapselungsschicht angeordnet auf der zweiten Elektrodenschicht (5), wobei eine Deckplatte aus Glas (11) mit einer vom Schichtstapel abgewandten Hauptoberfläche und Seitenoberflächen für die erste Verkapselungsschicht verwendet wird, und
- eine Diffusionsbarriere (12), die SiO₂ umfasst, welche gezielt auf den Seitenoberflächen des Schichtstapels und auf Teilen der Seitenoberflächen der Deckplatte mittels Atmosphärendruckplasmas abgeschieden ist, und
- die vom Schichtstapel abgewandte Hauptoberfläche der Deckplatte frei von der Diffusionsbarriere bleibt und das optoelektronische Bauelement so verkapselt ist, dass keine Kavität zwischen der Diffusionsbarriere (12) und dem Bauelement vorhanden ist.

## Claims

1. Method for encapsulating an optoelectronic component, comprising the method steps:
A) providing the optoelectronic component comprising the following method sub-steps:
A1) providing a substrate (1),
A1') applying a conductive transparent layer (2) to the substrate (1),
A2) applying a first electrode layer (3) to the conductive transparent layer (2),
A3) applying an organic functional layer (4) to the first electrode layer (3),
A4) applying a second electrode layer (5) to the organic functional layer (4),
wherein a layer stack is formed comprising the first electrode layer (3), the second electrode layer (5) and the organic functional layer (4), which layer stack has major surfaces and side surfaces
A5) applying a first encapsulating layer to the second electrode layer (5), wherein a cover plate made of glass (11) with a main surface facing away from the layer stack and with side surfaces is used for the first encapsulation layer,
B) targeted deposition of a diffusion barrier (12) for protection against environmental influences by means of an atmospheric pressure plasma on the side surfaces of the layer stack and on parts of the side surfaces of the cover plate,
wherein
- a plasma jet is used for the targeted deposition on the side surfaces of the layer stack and on parts of the side surfaces of the cover plate,
- the main surface of the cover plate facing away from the layer stack remains free of the diffusion barrier, and
- the optoelectronic component is encapsulated in such a way that no cavity is formed between the diffusion barrier (12) and the component.

2. Method according to the preceding claim,
wherein the diffusion barrier (12) is deposited with a thickness of 50 nm to 1000 nm.

3. Method according to one of the preceding claims,
wherein the diffusion barrier (12) is deposited in at least two individual layers with a thickness of 50 to 100 nm each.

4. Method according to one of the preceding claims,
wherein a thin-film encapsulating layer (6) is applied to the second electrode layer (5) in an additional method step after A4) .

5. Method according to the preceding claim,
wherein a second encapsulating layer (7) is applied to the thin-film encapsulating layer in an additional method step.

6. Optoelectronic component comprising
- a layer stack having major surfaces and side surfaces comprising
- a first substrate (1),
- a conductive transparent layer (2) arranged on the first substrate (1),
- a first electrode layer (3) arranged on the conductive transparent layer (2),
- an organic functional layer (4) arranged on the first electrode layer (3),
- a second electrode layer (5) arranged on the organic functional layer (4),
- a first encapsulating layer arranged on the second electrode layer (5), wherein a cover plate made of glass (11) with a main surface facing away from the layer stack and with side surfaces is used for the first encapsulation layer, and
- a diffusion barrier (12) comprising SiO₂ targeted deposited on the side surfaces of the layer stack and on parts of the side surfaces of the cover plate by means of atmospheric pressure plasma, and
- the main surface of the cover plate facing away from the layer stack remains free of the diffusion barrier and the optoelectronic component is encapsulated in such a way that there is no cavity between the diffusion barrier (12) and the component.

## Revendications

1. Procédé d'encapsulation d'un composant optoélectronique, comprenant les étapes de procédé suivantes:
A) fourniture du composant optoélectronique, comprenant les étapes de procédé partielles suivantes :
A1) fourniture d'un substrat (1),
A1') dépôt d'une couche transparente conductrice (2) sur le substrat (1),
A2) dépôt d'une première couche d'électrodes (3) sur la couche transparente conductrice (2),
A3) dépôt d'une couche fonctionnelle organique (4) sur la première couche d'électrodes (3),
A4) dépôt d'une seconde couche d'électrodes (5) sur la couche fonctionnelle organique (4),
un empilement de couches comprenant la première couche d'électrodes (3), la seconde couche d'électrodes (5) et la couche fonctionnelle organique (4) étant formé, comportant des surfaces principales et des surfaces latérales,
A5) dépôt d'une première couche d'encapsulation sur la seconde couche d'électrodes (5), une plaque de recouvrement en verre (11) ayant une surface principale opposée à l'empilement de couches et des surfaces latérales étant utilisée pour la première couche d'encapsulation,
B) précipitation ciblée d'une barrière de diffusion (12) de protection contre les influences environnementales moyennant un plasma à pression atmosphérique sur les surfaces latérales de l'empilement de couches et sur des parties des surfaces latérales de la plaque de recouvrement,
dans lequel
- on utilise un jet de plasma pour la précipitation ciblée sur les surfaces latérales de l'empilement de couches et sur des parties des surfaces latérales de la plaque de recouvrement,
- la surface principale de la plaque de recouvrement opposée à l'empilement de couches reste exempte de la barrière de diffusion, et
- le composant optoélectronique est encapsulé de manière à ne créer aucune cavité entre la barrière de diffusion (12) et le composant.

2. Procédé selon la revendication précédente, dans lequel l'épaisseur de précipitation de la barrière de diffusion (12) est de 50 à 1000 nm.

3. Procédé selon l'une des revendications précédentes, dans lequel
la barrière de diffusion (12) est précipitée sous forme d'au moins deux couches individuelles d'une épaisseur chacune comprise entre 50 et 100 nm.

4. Procédé selon l'une des revendications précédentes, dans lequel
dans une étape de procédé supplémentaire selon A4), une couche d'encapsulation en film mince (6) est déposée sur la seconde couche d'électrodes (5).

5. Procédé selon la revendication précédente, dans lequel,
dans une étape de procédé supplémentaire, une seconde couche d'encapsulation (7) est déposée sur la couche d'encapsulation en film mince (6).

6. Composant optoélectronique, comprenant
- un empilement de couches comportant des surfaces principales et des surfaces latérales, comprenant
- un premier substrat (1),
- une couche transparente conductrice (2) disposée sur le premier substrat (1),
- une première couche d'électrodes (3) disposée sur la couche transparente conductrice (2),
- une couche fonctionnelle organique (4) disposée sur la première couche d'électrodes (3),
- une seconde couche d'électrodes (5) disposée sur la couche fonctionnelle organique (4),
- une première couche d'encapsulation agencée sur la seconde couche d'électrodes (5), une plaque de recouvrement en verre (11) ayant une surface principale opposée à l'empilement de couches et des surfaces latérales étant utilisée pour la première couche d'encapsulation, et
- une barrière de diffusion (12) comprenant du SiO₂ précipitée de manière ciblée sur les surfaces latérales de l'empilement de couches et sur des parties des surfaces latérales de la plaque de recouvrement, et
- la surface principale de la plaque de recouvrement opposée à l'empilement de couches restant exempte de la barrière de diffusion et le composant optoélectronique étant encapsulé de manière à ne pas crée de cavité entre la barrière de diffusion (12) et le composant.
